# EUROPEAN PATENT APPLICATION

(11) **EP 4 435 856 A1**
(43) Date of publication of application: **25.09.2024**
(21) Application number: 24154945.0
(22) Date of filing: 31.01.2024
(51) Int. Cl.: H01L 25/075, H01L 33/62

(54) **DISPLAY DEVICE AND METHOD OF MANUFACTURING THE DISPLAY DEVICE**

(30) Priority: 24.03.2023 KR 20230039137; 11.05.2023 KR 20230061351
(71) Applicant: Samsung Electronics Co., Ltd., Suwon-si, Gyeonggi-do 16677 (KR)
(72) Inventor: HWANG, Kyungwook, 16678 Suwon-si (KR); HWANG, Junsik, 16678 Suwon-si (KR); KIM, Hakyeol, 16678 Suwon-si (KR); PARK, Jaewook, 16678 Suwon-si (KR); SONG, Sanghoon, 16678 Suwon-si (KR); SHIN, Jungwoon, 16678 Suwon-si (KR); LEE, Keunsik, 16678 Suwon-si (KR); LEE, Eungyeong, 16678 Suwon-si (KR)
(74) Representative: Elkington and Fife LLP

(57) **Abstract**

A display device having a perpendicular electrode structure and a method of manufacturing the display device are provided. The display device includes a display substrate including wiring therein, a first pad provided on the display substrate and connected to the wiring, a second pad provided on the display substrate, spaced apart from the first pad, and connected to the wiring, and a micro-semiconductor chip including a first electrode, a p-type semiconductor layer provided on the first electrode, an active layer provided on the p-type semiconductor layer, an n-type semiconductor layer provided on the active layer, and a second electrode provided on the n-type semiconductor layer, wherein the micro-semiconductor chip is constituted by a perpendicular electrode chip, the first electrode is connected to the first pad, and the second electrode is connected to the second pad.

## Description

### FIELD OF THE INVENTION

The disclosure relates to a display device having a perpendicular electrode structure and a method of manufacturing the display device.

### BACKGROUND OF THE INVENTION

Liquid crystal displays (LCDs) and organic light-emitting diode displays (OLEDs) have been widely used as display devices. Recently, there has been an increase in the adoption of micro light-emitting devices for manufacturing high-resolution display devices. Due to the low power-consuming and eco-friendly properties of light-emitting diodes (LEDs), the industrial demand therefor has been growing, and the LEDs have been employed not only in lighting systems or liquid crystal display (LCD) backlights, but also in display devices. In manufacturing a display device using a micro-semiconductor chip, a pick and place method has been widely used to transfer micro-semiconductor chips. However, with the continued reduction in the size of micro-semiconductor chips and the expansion in the size of display devices increases, such a method may now face challenges that could lead to decreased productivity.

In regard to a display device including a micro-semiconductor chip, diverse technologies, such as a transfer technology to transfer a micro-sized light-emitting device to a desired display pixel position, a repair process, and a method of implementing a desired color may be required.

### SUMMARY OF THE INVENTION

One or more example embodiments provide a display device having a perpendicular electrode structure.

Further, one or more example embodiments provide a method of manufacturing a display device having a perpendicular electrode structure.

Additional aspects will be set forth in part in the description which follows and, in part, will be apparent from the description, or may be learned by practice of the presented embodiments of the disclosure.

According to an aspect of the disclosure, a display device may include: a display substrate including wiring therein; a first pad provided on the display substrate and connected to the wiring; a second pad provided on the display substrate, spaced apart from the first pad, and connected to the wiring; and a micro-semiconductor chip including: a first electrode, a second electrode, and a p-type semiconductor layer, an active layer, and an n-type semiconductor layer that are provided between the first electrode and the second electrode, wherein the micro-semiconductor chip has a perpendicular electrode structure, in which the first electrode is connected to the first pad, and the second electrode is connected to the second pad, and wherein the second electrode is not in contact with the first pad at a position where the micro-semiconductor chip is absent.

The first pad is arranged not to overlap the second electrode or has a shape not to overlap the second electrode.

The display device may further include a dummy pad arranged between the first pad and the second pad on the display substrate and disconnected to the wiring.

The dummy pad may be arranged between the first pad and the second pad and may include a same material as the first pad.

The first pad may include a contact portion in contact with the first electrode and a recess portion accommodating a portion of the second electrode such that the second electrode is not in contact with the first pad when the micro-semiconductor chip is absent.

The first pad may have a circular shape with a rectangular-shaped recess, a rectangular shape with a rectangular-shaped recess, a C shape, or a semicircular shape.

The micro-semiconductor chip may include a first micro-semiconductor chip and a second micro-semiconductor chip, which are provided in one pixel constituting the display device, the first pad includes a pair of pads that are connected to the first micro-semiconductor chip and the second micro-semiconductor chip, respectively, and the second pad is connected to both of the first micro-semiconductor chip and the second micro-semiconductor chip.

The pair of pads of the first pad may have symmetrical shapes and a symmetrical arrangement with respect to the second pad.

According to another aspect of the disclosure, there is provided a method of manufacturing a display device by using a micro-semiconductor chip including a first electrode, an second electrode, and a p-type semiconductor layer, an active layer, and an n-type semiconductor layer that are provided between the first electrode and the second electrode. The method may include forming a first pad for the first electrode and a second pad for the second electrode on a display substrate including wiring therein; bonding the first electrode to the first pad by transferring the micro-semiconductor chip; stacking an insulating layer on the micro-semiconductor chip; exposing the n-type semiconductor layer of the micro-semiconductor chip and the second pad by patterning the insulating layer; and forming the second electrode on the exposed n-type semiconductor layer and the second pad, wherein the forming of the first pad may include forming the first pad in such a manner that the second electrode is not in contact with the first pad at a position where the micro-semiconductor chip is absent.

The forming of the first pad may include arranging the first pad not to overlap the second electrode or form ing the first pad to have a shape not to overlap the second electrode.

A dummy pad which is disconnected from the wiring may include further provided between the first pad and the second pad on the display substrate.

The dummy pad may be arranged between the first pad and the second pad and may include a same material as the first pad.

The first pad may include a contact portion in contact with the first electrode and a recess portion accommodating a portion of the second electrode such that the second electrode is not in contact with the first pad when the micro-semiconductor chip is omitted.

The first pad has a circular shape with a rectangular-shaped recess, a rectangular shape with a rectangular-shaped recess, a C shape, or a semicircular shape.

The micro-semiconductor chip may include a first micro-semiconductor chip and a second micro-semiconductor chip, which are provided in one pixel constituting the display device, the first pad may include a pair of pads that are connected to the first micro-semiconductor chip and the second micro-semiconductor chip, respectively, and the second pad may be connected to both of the first micro-semiconductor chip and the second micro-semiconductor chip.

The pair of pads of the first pad may have symmetrical shapes and a symmetrical arrangement with respect to the second pad.

According to another aspect of the present disclosure, a display device may include a plurality of pixels, wherein each of the plurality of pixels may include: a pair of first type pads configured to serve as contact points for a pair of micro-semiconductor chips, individually; and a second type pad that serves as a contact portion for both of the pair of micro-semiconductor chips, wherein the second type pad is positioned between the pair of first type pads, and wherein the pair of first type pads are symmetrically arranged with respect to the second type pad, such that a recessed portion on one of the first type pads directly faces a recessed portion on another one of the first type pads.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a diagram illustrating a display device having a perpendicular electrode structure according to an embodiment;
FIG. 2 is a diagram illustrating a transfer substrate used in manufacturing a display device having a perpendicular electrode structure according to an embodiment;
FIG. 3 is a diagram illustrating a display substrate of a display device having a perpendicular electrode structure according to an embodiment;
FIGS. 4, 5, and 6 are diagrams illustrating examples of a first pad employed in a display device having a perpendicular electrode structure according to an embodiment;
FIG. 7 is a diagram illustrating an example in which a dummy pad and a micro-semiconductor chip are provided in a display device having a perpendicular electrode structure;
FIG. 8 is a diagram illustrating an example in which a dummy pad is provided in a display device having a perpendicular electrode structure while a micro-semiconductor chip is omitted;
FIG. 9 is a diagram illustrating a transfer substrate including a micro-semiconductor chip in one pixel in a display device having a perpendicular electrode structure;
FIG. 10 is a diagram illustrating a display substrate corresponding to the transfer substrate illustrated in FIG. 9;
FIG. 11 is a diagram illustrating a case where a micro-semiconductor chip is omitted in a display device in which one micro-semiconductor chip is provided in one pixel;
FIG. 12 is a diagram illustrating a method of transferring a micro-semiconductor chip in a method of manufacturing a display device according to an embodiment;
FIGS. 13A, 13B, 13C, and 13D are diagrams illustrating a method of manufacturing a display device according to an embodiment;
FIG. 14 is a diagram illustrating a transfer substrate in which three micro-semiconductor chips are provided in one pixel;
FIG. 15 is a diagram illustrating a transfer substrate in which six micro-semiconductor chips are provided in one pixel;
FIG. 16 is a diagram illustrating a transfer substrate in which two micro-semiconductor chips are provided in one pixel;
FIG. 17 is a diagram illustrating a transfer substrate in which four micro-semiconductor chips are provided in one pixel;
FIG. 18 is a schematic block diagram of an electronic device according to an embodiment;
FIG. 19 is a diagram illustrating an example in which a display device according to an embodiment is applied to a mobile device;
FIG. 20 is a diagram illustrating an example in which a display device according to an embodiment is applied to a display device for vehicles;
FIG. 21 is a diagram illustrating an example in which a display device according to an embodiment is applied to augmented reality glasses;
FIG. 22 is a diagram illustrating an example in which a display device according to an embodiment is applied to signage; and
FIG. 23 is a diagram illustrating an example in which a display device according to an embodiment is applied to a wearable display.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a display device having a perpendicular electrode structure and a manufacturing method thereof according to various embodiments are described in detail with reference to the attached drawings. In the drawings, like reference numerals in the drawings denote like elements, and sizes of components in the drawings may be exaggerated for clarity and convenience of explanation. While such terms as "first," "second," etc., may be used to describe various components, such components must not be limited to the above terms. The above terms are used only to distinguish one component from another.

An expression used in the singular encompasses the expression of the plural, unless it has a clearly different meaning in the context. When a portion "includes" an element, another element may be further included, rather than excluding the existence of the other element, unless otherwise described. Sizes or thicknesses of components in the drawings may be arbitrarily exaggerated for convenience of explanation. Further, when a certain material layer is described as being arranged on a substrate or another layer, the material layer may be in contact with the other layer, or there may be a third layer between the material layer and the other layer. In embodiments, materials constituting each layer are provided merely as an example, and other materials may also be used.

Moreover, the terms "part," "module," etc. refer to a unit processing at least one function or operation, and may be implemented by a hardware, a software, or a combination thereof.

The particular implementations shown and described herein are illustrative examples of embodiments and are not intended to otherwise limit the scope of embodiments in any way. For the sake of brevity, conventional electronics, control systems, software development and other functional aspects of the systems may not be described in detail. Furthermore, the connecting lines, or connectors shown in the various figures presented are intended to represent exemplary functional relationships and/or physical or logical couplings between the various elements. It should be noted that many alternative or additional functional relationships, physical connections or logical connections may be present in a practical device.

The use of the terms "a" and "an" and "the" and similar referents in the context of describing embodiments (especially in the context of the following claims) are to be construed to cover both the singular and the plural.

Also, the steps of all methods described herein can be performed in any suitable order unless otherwise indicated herein or otherwise clearly contradicted by context. The use of any and all exemplary languages (e.g., "such as") provided herein, are intended merely to better illuminate the technical ideas and does not pose a limitation on the scope of rights unless otherwise claimed.

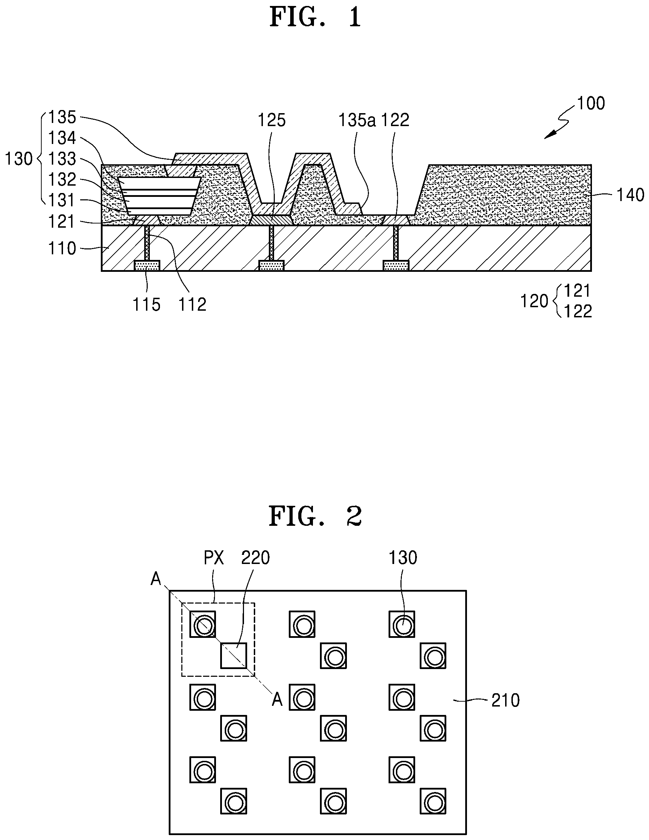

FIG. 1 is a diagram of a display device according to an embodiment.

A display device 100 may include a display substrate 110 including wiring 112 therein, a first pad 120 provided on the display substrate 110, a second pad 125 provided on the display substrate 110 and spaced apart from the first pad 120, and a micro-semiconductor chip 130 electrically connected to the first pad 120 and the second pad 125. The term "pad," which is also referred to as a contact pad, may be a metallic area that serves as connection points for electronic connections. The first pad 120 may include a plurality of pads, wherein each of the pads is designated for a specific micro-semiconductor chip among a plurality of semiconductor chips, and the plurality of semiconductor chips share a common pad (e.g., the second pad 125). For example, the first pad 120 may include a pair of P-type contact pads (e.g., a 1-1 pad 121 and a 1-2 pad 122) for providing electrical connection to two micro-semiconductor chips, and a common N-type contact pad (e.g., the second pad 125) is positioned between the P-type contact pads to serve the two micro-semiconductor chips.

The display substrate 110 may include a drive device 115 driving the micro-semiconductor chip 130, and the drive device 115 may include at least one capacitor and at least one transistor. The drive device 115 may be electrically connected to the micro-semiconductor chip 130 through the wiring 112.

The micro-semiconductor chip 130 may include various types of micro-semiconductor chips having a micro size, and the micro size may be less than or equal to 1000 µm or 200 µm. The micro-semiconductor chip 130 may include, for example, a light-emitting diode (LED), a complementary metal-oxide semiconductor (CMOS), a CMOS image sensor (CIS), a vertical-cavity surface-emitting laser (VCSEL), a photo diode (PD), a memory device, a two-dimensional (2D) material device, etc. The 2D material may be graphene or carbon nano tube (CNT).

The micro-semiconductor chip 130 may include a first electrode 131, a first type semiconductor layer 132 provided on the first electrode 131, an active layer 133 provided on the first type semiconductor layer 132, and a second type semiconductor layer 134 provided on the active layer 133. A second electrode 135 may be provided on the second type semiconductor layer 134.

The first type semiconductor layer 132 may be a p-type semiconductor layer. The first type semiconductor layer 132 may include III-V group p-type semiconductors, for example, p-GaN. The first type semiconductor layer 132 may have a single layer structure or a multi-layer structure.

The active layer 133 may be provided on the first type semiconductor layer 132. When an electron and a hole are coupled, the active layer 133 may generate light. The active layer 133 may have a multi-quantum well (MQW) structure, or a single-quantum well (SQW) structure. The active layer 133 may include III-V group semiconductors, for example, GaN.

The second type semiconductor layer 134 may be provided on an upper surface of the active layer 133. The second type semiconductor layer 134 may be, for example, an n-type semiconductor layer. The second type semiconductor layer 134 may include III-V group n-type semiconductors, for example, n-GaN. The second type semiconductor layer 134 may have a single layer structure or a multi-layer structure. Alternatively, when the first type semiconductor layer 132 is an n-type semiconductor layer, the second type semiconductor layer 134 may be a p-type semiconductor layer.

The first electrode 131 may be connected to the first pad 120, and the second electrode 135 may be connected to the second pad 125. The micro-semiconductor chip 130 may have a perpendicular electrode structure in which the first electrode 131 is provided on one surface, and the second electrode 135 is provided on a surface facing the surface on which the first electrode 131 is provided. The first pad 120 may be arranged to at least partially overlap the first electrode 131 to be in contact with the first electrode 131. The first pad 120 may be connected to the first electrode 131 when the micro-semiconductor chip 130 is provided, and may be arranged not in contact with (i.e. not in physical contact with) the second electrode 135 at a position where the micro-semiconductor chip 130 is omitted. That is, at a position where the micro-semiconductor chip 130 is omitted, the second electrode 135 may not be in physical contact with the first pad 120 (e.g. the first pad 120 may be physically isolated, distanced or spaced apart from the second electrode 135). For example, the first pad 120 may be arranged not to overlap the second electrode 135 or have a shape not to overlap the second electrode 135. Here, when the first pad 120 does not overlap the second electrode 135, it signifies that when the second electrode 135 is projected onto the display substrate 110, there is no physical and electric contact between the first pad 120 and the second electrode 135. This configuration is implemented to ensure that the second electrode 135 remains separate from the first pad 120, particularly in cases where the micro-semiconductor chip 130 is omitted. That is, by arranging the first pad 120 in a manner that avoids overlap with the second electrode 135, unintentional connection and short-circuiting between the second electrode 135 and the first pad 120 may be prevented when the micro-semiconductor chip 130 is omitted.

In another embodiment, at a position where the micro-semiconductor chip 130 is omitted, when the second electrode 135 extends to a place where the micro-semiconductor chip 130 would normally be placed (but is currently missing), an extension 135a of the second electrode 135 may be positioned so as not to make contact with the first pad 120.

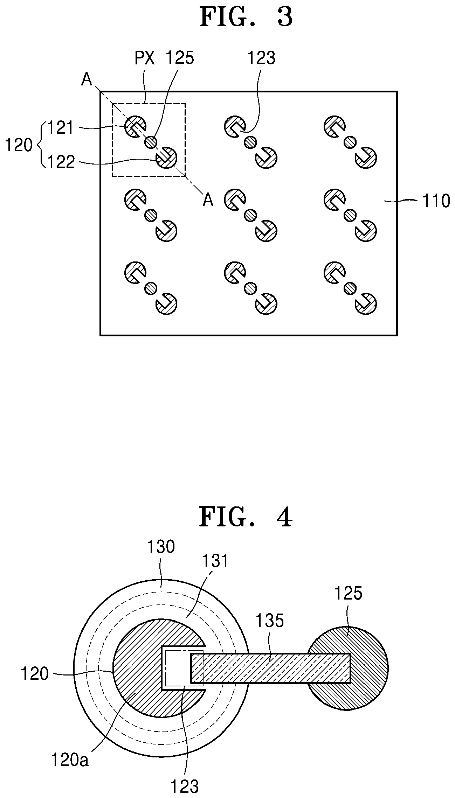

FIG. 1 illustrates an example in which two micro-semiconductor chips 130 are provided in one pixel. To further describe the above in detail, FIG. 2 illustrates that the micro-semiconductor chip 130 is transferred onto a transfer substrate 210, and FIG. 3 illustrates the display substrate 110 including the first pad 120 and the second pad 125. The transfer substrate 210 may include a plurality of grooves 220, and the plurality of grooves 220 may be provided for arrangement of the micro-semiconductor chip 130. Two grooves 220 may be included in one pixel PX of the transfer substrate 210, and the micro-semiconductor chip 130 may be transferred to each of the two grooves 220. Transferring a plurality of micro-semiconductor chips 130 in one pixel PX is to ensure that even when one micro-semiconductor chip 130 is omitted, the rest of micro-semiconductor chips 130 may operate without requiring a separate repair process. FIG. 2 illustrates a case in which one micro-semiconductor chip 130 is omitted.

Referring to FIG. 3, the first pad 120 may include a 1-1 pad 121 coupled to the first electrode 131 of one micro-semiconductor chip 130 and a 1-2 pad 122 coupled to the first electrode 131 of another micro-semiconductor chip 130. The 1-1 pad 121 and the 1-2 pad 122 may be spaced apart from each other, and the second pad 125 may be arranged between the 1-1 pad 121 and the 1-2 pad 122. The 1-1 pad 121 may be arranged symmetrically with the 1-2 pad 122 with respect to the second pad 125. The 1-1 pad 121 may have a "C" shape, and the 1-2 pad 122 may have a "reversed C" shape. That is, the 1-2 pad 122 may have a shape symmetrical with the shape of the 1-1 pad 121, taking into account the second pad 125 as a reference point. This arrangement allows that the 1-1 pad 121 and the 1-2 pad 122 are positioned in a mirrored fashion with respect to the second pad 125. The specific shape of the 1-1 pad 121 and the 1-2 pad 122 may prevent the second electrode 135 from being unintentionally connected to the 1-1 pad 121 or the 1-2 pad 122 and short-circuited when the micro-semiconductor chip 130 is omitted.

By arranging the transfer substrate 210 of FIG. 2 and the display substrate 110 of FIG. 3 to face each other, the micro-semiconductor chip 130 may be transferred to the display substrate 110.

Referring to FIG. 1, when the micro-semiconductor chip 130 is omitted, the second electrode 135 does not make contact with the 1-2 pad 122, ensuring that electrical short circuits are prevented. FIG. 1 illustrates a cross-section taken along line A-A of FIGS. 2 and 3.

FIG. 4 illustrates a coupling relation among the first pad 120, the second electrode 135, and the second pad 125 when the micro-semiconductor chip 130 is omitted. The first pad 120 may include a contact portion 120a in contact with the first electrode 131 and a recess portion 123 accommodating a portion of the second electrode 135 such that the second electrode 135 is not in contact with the first pad 120 when the micro-semiconductor chip 130 is omitted. The first pad 120 may have a circular shape with a rectangular-shaped recess. A part of the second electrode 135 may be arranged in the recess portion 123 of the first pad 120 and the second electrode 135 may not be in contact with the first pad 120. The shape and position of the first pad 120 are not limited thereto, and when the micro-semiconductor chip 130 is normally provided, to such an extent that the first pad 120 is in contact with the first electrode 131, when the micro-semiconductor chip 130 is omitted, the shape and the position of the first pad 120 may be changed in various ways to satisfy the condition that the first pad 120 is not in contact with the second electrode 135.

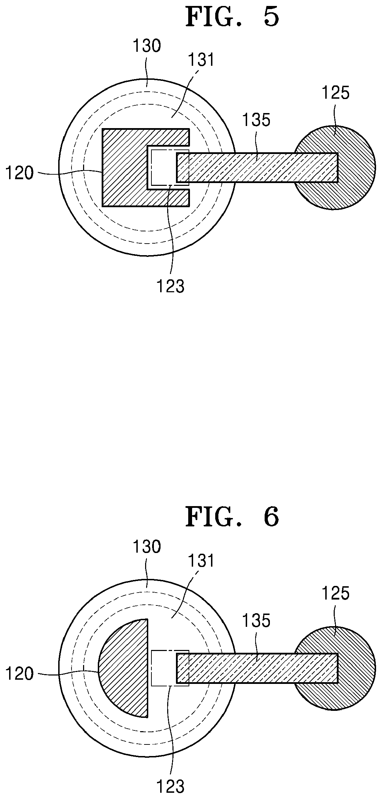

Referring to FIG. 5, when the first pad 120 has a shape of the Korean character " 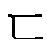 " and includes the recess portion 123, and the micro-semiconductor chip 130 is omitted, the second electrode 135 may be positioned in the recess portion 123 of the first pad 120 and the second electrode 135 may not be in contact with the first pad 120. The first pad 120 may have a rectangular shape with a rectangular-shaped recess.

Referring to FIG. 6, when the first pad 120 has a semicircular shape and the micro-semiconductor chip 130 is omitted, the second electrode 135 may be arranged in a place where the first pad 120 is not provided such that the second electrode 135 is not in contact with the first pad 120.

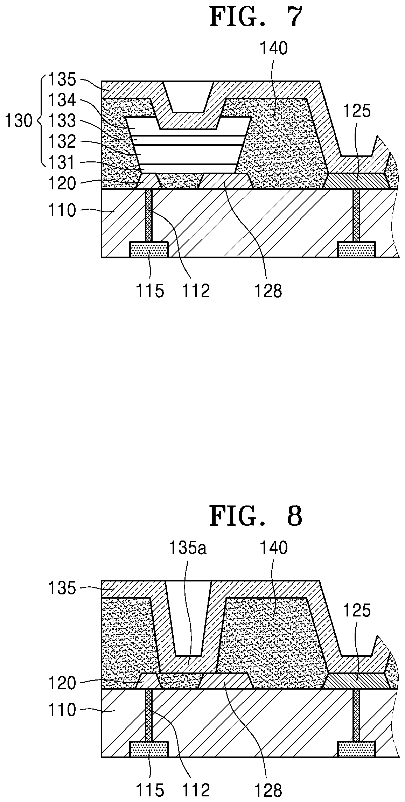

FIGS. 7 and 8 illustrate an examples in which a dummy pad is further provided in the display device illustrated in FIG. 1. The components denoted by the same reference numerals as in FIG. 1 are substantially identical to the components of FIG. 1, and thus any redundant description is omitted. A dummy pad 128 may be arranged adjacent to the first pad 120. That is, the dummy pad 128 may be arranged between the first pad 120 and the second pad 125. The dummy pad 128 may refer to a pad which is not electrically connected to the display substrate 110. The dummy pad 128 may not be connected to the wiring 112. The dummy pad 128, which is disconnected to the wiring 112, may be arranged on the display substrate 110 in an area where the first electrode 131 and the second electrode 135 overlap each other. In embodiments of the disclosure, the dummy pad 128 may include the same conductive material as the first pad 120, but as the dummy pad 128 is not connected to the wiring 112, the dummy pad 128 may not serve any electrical function. However, the presence of the dummy pad 128 may facilitate stable bonding between the micro-semiconductor chip 130 and the display substrate 110. Alternatively, the dummy pad 128 may include a material with low electrical conductivity or act as an electrical insulator to prevent an electrical connection between the micro-semiconductor chip 130 and the display substrate 110.

FIG. 7 illustrates the case where the micro-semiconductor chip 130 is normally provided on the display substrate 110, and FIG. 8 illustrates the case where the micro-semiconductor chip 130 is omitted. Referring to FIG. 7, the first electrode 131 of the micro-semiconductor chip 130 may be connected to the first pad 120 and supported by the dummy pad 128, and the second electrode 135 may be connected to the second pad 125. Referring to FIG. 8, when the micro-semiconductor chip 130 is omitted, the extension 135a of the second electrode 135 may be arranged not to be in contact with the first pad 120 and in contact with the dummy pad 128. As the dummy pad 128 is not electrically connected, even when the dummy pad 128 is in contact with the second electrode 135, shorting may not occur.

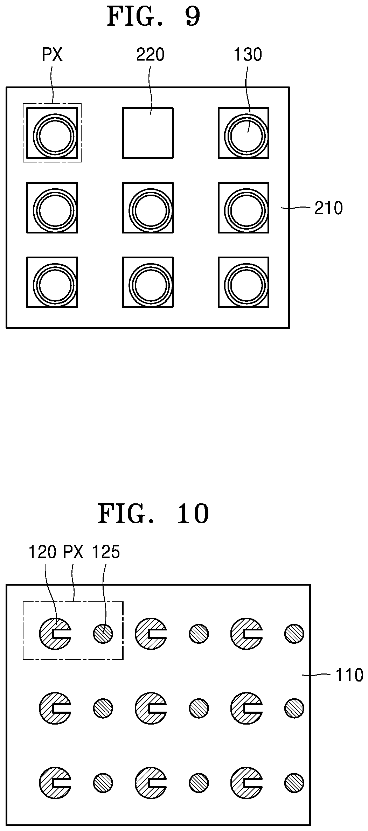

FIG. 9 illustrates the transfer substrate 210 in which one micro-semiconductor chip 130 is transferred to one pixel PX. FIG. 10 is a diagram illustrating the display substrate 110 corresponding to the transfer substrate 210 of FIG. 9. One pixel PX of the display substrate 110 may include one first pad 120 and one second pad 125.

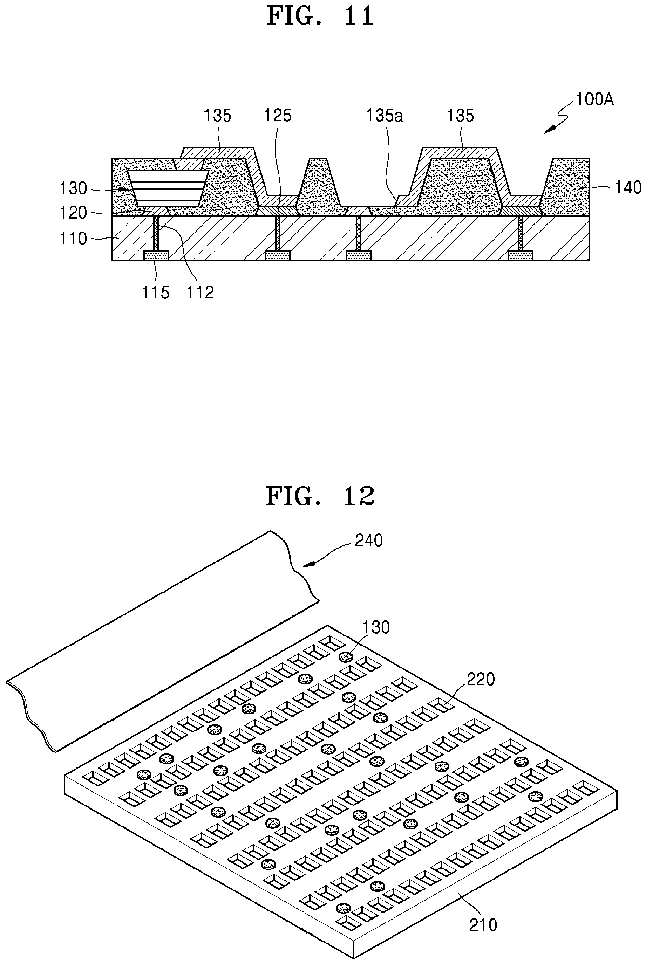

FIG. 11 illustrates a display device 100A in which one micro-semiconductor chip 130 is provided in one pixel. In FIG. 11, the components denoted by the same reference numerals as in FIG. 1 are substantially identical to the components of FIG. 1, and thus any redundant description is omitted.

Referring to FIG. 11, when the micro-semiconductor chip 130 is provided, the first electrode 131 may be connected to the first pad 120, and the second electrode 135 may be connected to the second pad 125. When the micro-semiconductor chip 130 is omitted, the second electrode 135 may not be in contact with the first pad 120 and only in contact with the second pad 125.

When the micro-semiconductor chip 130 is omitted, in the display device 100A, the first pad 120 may be provided not to be placed at a position where the second electrode 135 is connected to the display substrate 110 or may have a shape which has no connection with the second electrode 135. That is, the extension 135a of the second electrode 135 which extends to a position where the micro-semiconductor chip 130 is omitted may be placed not be in contact with the first pad 120. By doing so, the second electrode 135 may be prevented from being connected to the first pad 120 and electrically shorted.

Next, a method of manufacturing a display device according to an embodiment is described.

FIG. 12 illustrates transfer of the micro-semiconductor chip 130 to the transfer substrate 210.

The micro-semiconductor chip 130 may be transferred to the transfer substrate 210 by using various methods. The micro-semiconductor chip 130 may be transferred by using a dry transfer method such as pick and place method or a wet transfer method using liquid.

FIG. 12 illustrate an example of wet transfer method.

The transfer substrate 210 including a plurality of grooves 220 may be provided. The transfer substrate 210 may include a single layer or multi-layers. The grooves 220 may be provided to place the micro-semiconductor chip 130. The micro-semiconductor chip 130 may include, for example, a light-emitting diode (LED), a complementary metal-oxide semiconductor (CMOS), a CMOS image sensor (CIS), a vertical-cavity surface-emitting laser (VCSEL), a photo diode (PD), a memory device, a two-dimensional (2D) material device, etc. The 2D material may be graphene or carbon nano tube (CNT).

Liquid may be provided to the grooves 220. Any kind of liquid that does not corrode or damage the micro-semiconductor chip 130 may be used. The liquid may include, for example, one or more combinations selected from a group consisting of water, ethanol, alcohol, polyol, keton, halocarbon, acetone, flux, and organic solvent. The organic solvent may include, for example, isopropyl alcohol (IPA). The kind of liquid is not limited thereto, and may be changed diversely.

A method of providing liquid to the grooves 220 may include, for example, a spray method, a dispensing method, an inkjet dot method, a method of flowing liquid to the transfer substrate 210, etc. The amount of liquid supply may be adjusted variably to exactly fill or overfill the grooves 220.

A plurality of micro-semiconductor chips 130 may be provided to the transfer substrate 210. The micro-semiconductor chip 130 may be sprayed to the transfer substrate 210 without other liquids, or may be supplied in a suspension. A method of providing the micro-semiconductor chip 130 included in a suspension may include, for example, a spray method, a dispensing method, by which liquid is provided dropwise, an inkjet dot method, by which liquid is discharged like a printing method, a method of flowing the suspension to the transfer substrate 210, etc.

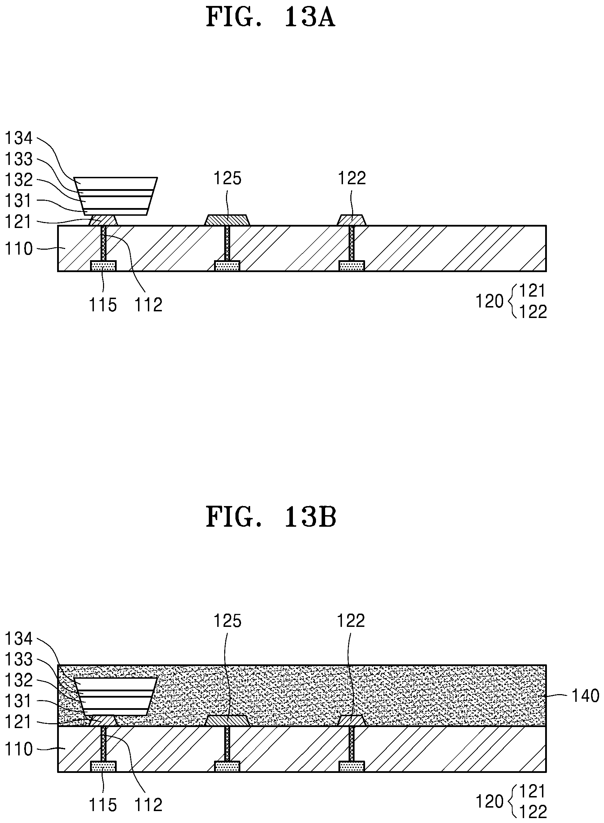

By scanning the transfer substrate 210 by using a wiper 240, the micro-semiconductor chip 130 may be transferred to the grooves 220. The micro-semiconductor chip 130 may be transferred in a manner that the first electrode 131 (see FIG. 13A) is directed towards an upper portion of the grooves 220.

Referring to FIG. 13A, the micro-semiconductor chip 130 transferred to the transfer substrate 210 may be transferred to the display substrate 110. The transfer substrate 210 may be bonded to the display substrate 110 arranged to face the transfer substrate 210, and then by removing the transfer substrate 210, the structure of FIG. 13A may be obtained.

The display substrate 110 may include the wiring 112 provided therein. The first pad 120 and the second pad 125 may be provided on the display substrate 110. The first pad 120 may be connected to the first electrode 131 of the micro-semiconductor chip 130, and the second pad 125 may be connected to the second electrode 135 of the micro-semiconductor chip 130.

FIG. 13A illustrates the case in which the micro-semiconductor chip 130 is omitted.

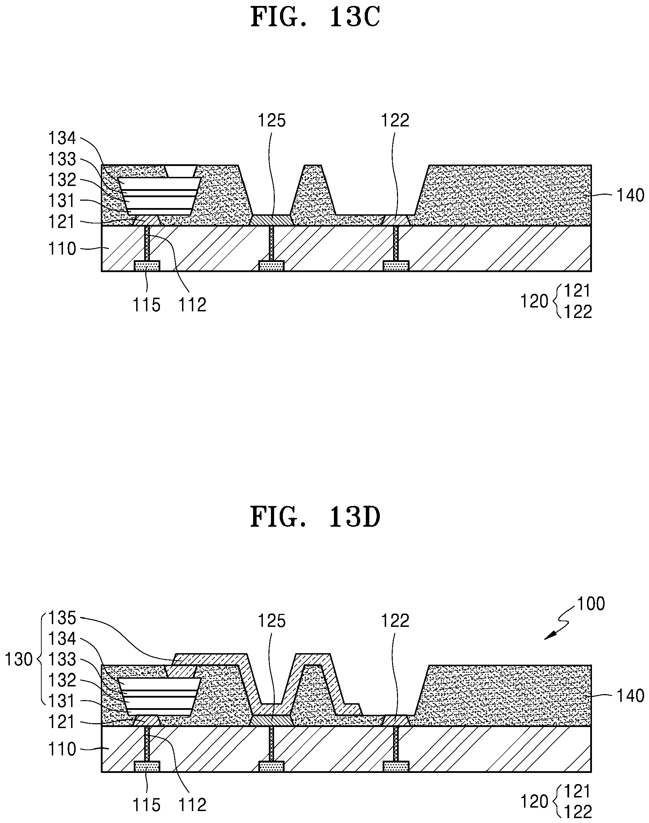

Referring to FIG. 13B, an insulating layer 140 may be stacked to cover the micro-semiconductor chip 130. Referring to FIG. 13C, by patterning the insulating layer 140, the n-type semiconductor layer 134 of the micro-semiconductor chip 130 and the second pad 125 may be exposed. At a position where the micro-semiconductor chip 130 is omitted, the 1-2 pad 122 may be exposed. Referring to FIG.13D, the second electrode 135 may be formed at the exposed n-type semiconductor layer 134 and the second pad 125. Forming of the first pad 120 may include forming the first pad 120 not to be in contact with the second electrode 135 at a position where the micro-semiconductor chip 130 is omitted. By doing so, even when the micro-semiconductor chip 130 is omitted, electrical shorting may be prevented.

The micro-semiconductor chip 130 may have a perpendicular electrode structure in which the first electrode 131 is provided on one surface, and the second electrode 135 is provided on a surface facing the surface on which the first electrode 131 is provided. When the micro-semiconductor chip 130 is normally connected to the display substrate 110, the first electrode 131 may be connected to the first pad 120, and the second electrode 135 may be connected to the n-type semiconductor layer 134 and the second pad 125 to have a normal electrical connection structure. When the micro-semiconductor chip 130 is omitted, as the first pad 120 is designed in such a manner that the second electrode 135 is not in contact with the first pad 120, the second electrode 135 may be prevented from being connected to the first pad 120 and shorted.

When connecting electrodes by using a perpendicular chip, the first electrode 131 may be directly connected to the first pad 120 of the display substrate 110 through bonding, and the second electrode 135 may be connected after the bonding on the opposite side of the first electrode 131. In this case, due to the absence of a micro-semiconductor chip, an electrical shorting according to the contact between the second electrode 135 and the first pad 120 may occur. In such a case, in an embodiment, by having an electrode structure in which the first pad 120 is not connected to the second electrode 135, the aforementioned shorting issue may be overcome.

As for a method of manufacturing a display deice, in various processes which require a process of moving a plurality of chips to a transfer substrate through a transfer process, to facilitate operations of sub-pixels and minimize a repair process, a redundancy process by which a plurality of semiconductor chips are arranged and transferred in one pixel may be applied. In this case, an electrode needs to be connected to each micro-semiconductor chip, and by avoiding electrode connection in an empty area where the micro-semiconductor chip is omitted, the shorting issue may be overcome without a separate repair process.

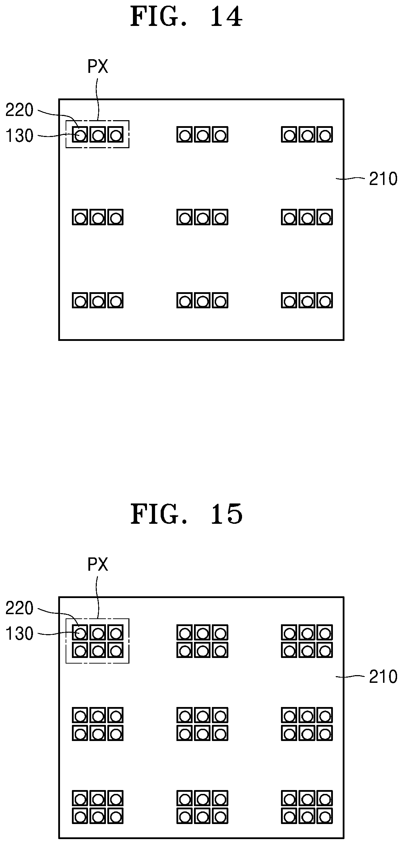

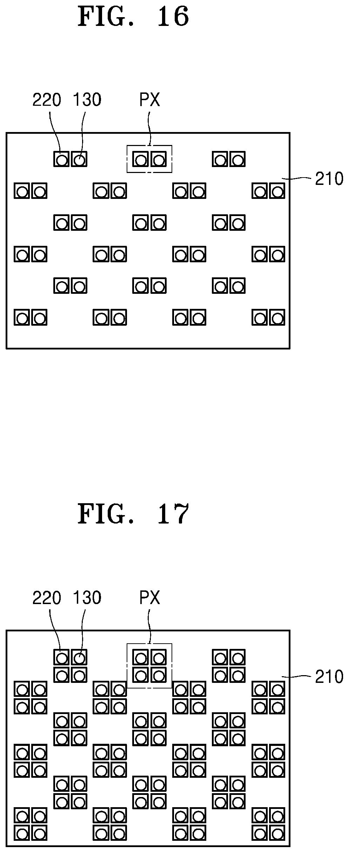

FIGS. 14 to 17 illustrate examples of a redundancy arrangement structure in which a plurality of micro-semiconductor chip are transferred to one pixel PX. Referring to FIG. 14, three micro-semiconductor chips 130 are transferred in line to one pixel PX of the transfer substrate 210. FIG. 15 illustrates an example in which 2x3 redundancy arrangement structure is applied to one pixel PX. FIG. 16 illustrates an example in which two micro-semiconductor chips 130 are transferred to one pixel PX. FIG. 17 illustrates an example in which four micro-semiconductor chips 130 are transferred to one pixel PX. FIGS. 14 and 15 illustrate a redundancy arrangement structure having a stripe pattern, and FIG. 16 illustrates a pentile redundancy arrangement structure. The display device according to an embodiment may be applied to any types of redundancy arrangement structure.

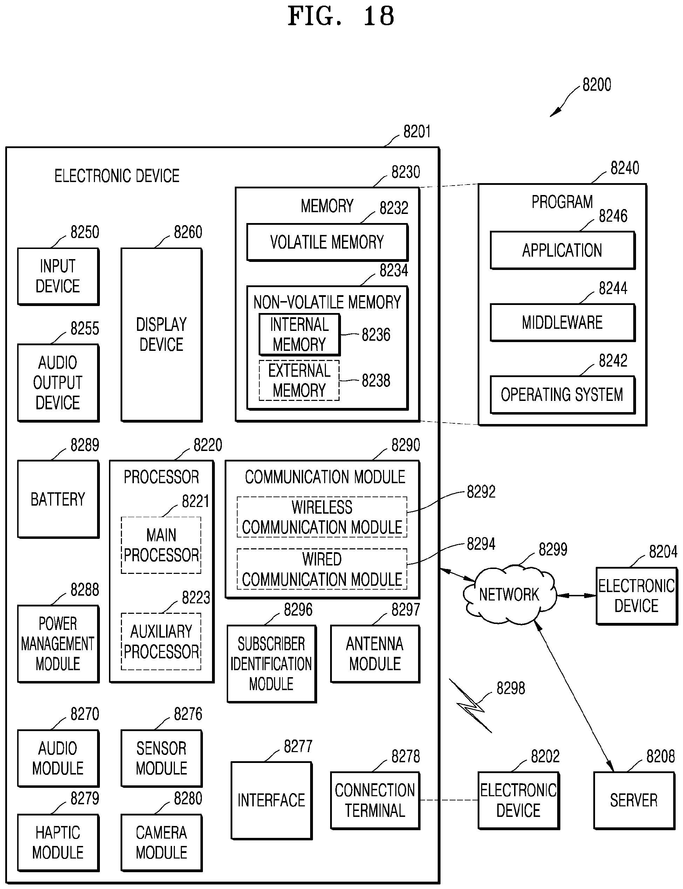

FIG. 18 is a block diagram of an electronic device including a display device according to an embodiment.

Referring to FIG. 18, an electronic device 8201 may be provided in a network environment 8200. In the network environment 8200, the electronic device 8201 may communicate with another electronic device 8202 through a first network 8298 (a short-range wireless communication network, etc.) or communicate with another electronic device 8204 and/or a server 8208 through a second network 8299 (a long-distance wireless communication network, etc.). The electronic device 8201 may communicate with the electronic device 8204 through the server 8208. The electronic device 8201 may include a processor 8220, a memory 8230, an input device 8250, an audio output device 8255, a display device 8260, an audio module 8270, a sensor module 8276, an interface 8277, a haptic module 8279, a camera module 8280, a power management module 8288, a battery 8289, a communication module 8290, a subscriber identification module 8296, and/or an antenna module 8297. In the electronic device 8201, some of constituent elements may be omitted or other constituent elements may be added. Some of the constituent elements may be implemented by one integrated circuit. For example, the sensor module 8276 (a fingerprint sensor, an iris sensor, an illuminance sensor, and the like) may be implemented by being embedded in the display device 8260 (a display, and the like).

The processor 8220 may control one or a plurality of other constituent elements (hardware and software constituent elements, and the like) of the electronic device 8201 connected to the processor 8220 by executing software (a program 8240, and the like), and perform various data processing or calculations. As part of the data processing or calculations, the processor 8220 may load, in a volatile memory 8232, commands and/or data received from other constituent elements (the sensor module 8276, the communication module 8290, and the like), process the command and/or data stored in the volatile memory 8232, and store result data in a non-volatile memory 8234. The non-volatile memory 8234 may include an internal memory 8236 and an external memory 8238. The processor 8220 may include a main processor 8221 (a central processing unit, an application processor, and the like) and an auxiliary processor 8223 (a graphics processing unit, an image signal processor, a sensor hub processor, a communication processor, and the like) that is operable independently of or together with the main processor 8221. The auxiliary processor 8223 may use less power than the main processor 8221 and may perform a specialized function.

Instead of the main processor 8221 when the main processor 8221 is in an inactive state (sleep state), or with the main processor 8221 when the main processor 8221 is in an active state (application execution state), the auxiliary processor 8223 may control functions and/or states related to some constituent elements (the display device 8260, the sensor module 8276, the communication module 8290, and the like) of the constituent elements of the electronic device 8201. The auxiliary processor 8223 (an image signal processor, a communication processor, and the like) may be implemented as a part of functionally related other constituent elements (the camera module 8280, the communication module 8290, and the like).

The memory 8230 may store various data needed by the constituent elements (the processor 8220, the sensor module 8276, and the like) of the electronic device 8201. The data may include, for example, software (the program 8240, and the like) and input data and/or output data about commands related thereto. The memory 8230 may include the volatile memory 8232 and/or the non-volatile memory 8234.

The program 8240 may be stored in the memory 8230 as software, and may include an operating system 8242, middleware 8244, and/or an application 8246.

The input device 8250 may receive commands and/or data to be used for constituent elements (the processor 8220, and the like) of the electronic device 8201, from the outside (a user, and the like) of the electronic device 8201. The input device 8250 may include a remote controller, a microphone, a mouse, a keyboard, and/or a digital pen (a stylus pen, and the like).

The audio output device 8255 may output an audio signal to the outside of the electronic device 8201. The audio output device 8255 may include a speaker and/or a receiver. The speaker may be used for general purposes such as multimedia playback or recording playback, and the receiver can be used to receive incoming calls. The receiver may be implemented by being coupled as a part of the speaker or by an independent separate device.

The display device 8260 may visually provide information to the outside of the electronic device 8201. The display device 8260 may include a display, a hologram device, or a projector, and a control circuit to control a corresponding device. The display device 8260 may include the display device according to an embodiment. The display device 8260 may include a touch circuitry set to detect a touch and/or a sensor circuit (a pressure sensor, and the like) set to measure the strength of a force generated by the touch.

The audio module 8270 may convert sound into electrical signals or reversely electrical signals into sound. The audio module 8270 may obtain sound through the input device 8250, or output sound through a speaker and/or a headphone of another electronic device (the electronic device 8202, and the like) connected to the audio output device 8255 and/or the electronic device 8201 in a wired or wireless manner.

The sensor module 8276 may detect an operation state (power, temperature, and the like) of the electronic device 8201, or an external environment state (a user state, and the like), and generate an electrical signal and/or a data value corresponding to a detected state. The sensor module 8276 may include a gesture sensor, a gyro sensor, a barometric pressure sensor, a magnetic sensor, an acceleration sensor, a grip sensor, a proximity sensor, a color sensor, an IR sensor, a biometric sensor, a temperature sensor, a humidity sensor, and/or an illuminance sensor.

The interface 8277 may support one or more specified protocols used for the electronic device 8201 to be connected to another electronic device (the electronic device 8202, and the like) in a wired or wireless manner. The interface 8277 may include a high-definition multimedia interface (HDMI), a universal serial bus (USB) interface, an SD card interface, and/or an audio interface.

A connection terminal 8278 may include a connector for the electronic device 8201 to be physically connected to another electronic device (the electronic device 8202, and the like). The connection terminal 8278 may include an HDMI connector, a USB connector, an SD card connector, and/or an audio connector (a headphone connector, and the like).

The haptic module 8279 may convert electrical signals into mechanical stimuli (vibrations, movements, and the like) or electrical stimuli that are perceivable by a user through tactile or motor sensations. The haptic module 8279 may include a motor, a piezoelectric device, and/or an electrical stimulation device.

The camera module 8280 may capture a still image and a video. The camera module 8280 may include a lens assembly including one or more lenses, image sensors, image signal processors, and/or flashes. The lens assembly included in the camera module 8280 may collect light emitted from a subject for image capturing.

The power management module 8288 may manage power supplied to the electronic device 8201. The power management module 1188 may be implemented as a part of a power management integrated circuit (PMIC).

The battery 8289 may supply power to the constituent elements of the electronic device 8201. The battery 8289 may include non-rechargeable primary cells, rechargeable secondary cells, and/or fuel cells.

The communication module 8290 may establish a wired communication channel and/or a wireless communication channel between the electronic device 8201 and another electronic device (the electronic device 8202, the electronic device 8204, the server 8208, and the like), and support a communication through an established communication channel. The communication module 8290 may be operated independent of the processor 8220 (the application processor, and the like), and may include one or more communication processors supporting a wired communication and/or a wireless communication. The communication module 8290 may include a wireless communication module 8292 (a cellular communication module, a short-range wireless communication module, a global navigation satellite system (GNSS) communication module, and the like), and/or a wired communication module 8294 (a local area network (LAN) communication module, a power line communication module, and the like). Among the above communication modules, a corresponding communication module may communicate with another electronic device through the first network 8298 (a short-range communication network such as Bluetooth, WiFi Direct, or infrared data association (IrDA)) or the second network 8299 (a long-range communication network such as a cellular network, the Internet, or a computer network (LAN, WAN, and the like)). These various types of communication modules may be integrated into one constituent element (a single chip, and the like), or may be implemented as a plurality of separate constituent elements (multiple chips). The wireless communication module 8292 may verify and authenticate the electronic device 8201 in a communication network such as the first network 8298 and/or the second network 8299 by using subscriber information (an international mobile subscriber identifier (IMSI), and the like) stored in the subscriber identification module 8296.

The antenna module 8297 may transmit signals and/or power to the outside (another electronic device, and the like) or receive signals and/or power from the outside. An antenna may include an emitter formed in a conductive pattern on a substrate (a printed circuit board (PCB), and the like). The antenna module 8297 may include one or a plurality of antennas. When the antenna module 8297 includes a plurality of antennas, the communication module 8290 may select, from among the antennas, an appropriate antenna for a communication method used in a communication network such as the first network 8298 and/or the second network 8299. Signals and/or power may be transmitted or received between the communication module 8290 and another electronic device through the selected antenna. Other parts (an RFIC, and the like) than the antenna may be included as a part of the antenna module 8297.

Some of the constituent elements may be connected to each other through a communication method between peripheral devices (a bus, general purpose input and output (GPIO), a serial peripheral interface (SPI), a mobile industry processor interface (MIPI), and the like) and may mutually exchange signals (commands, data, and the like).

The command or data may be transmitted or received between the electronic device 8201 and the external electronic device 8204 through the server 8208 connected to the second network 8299. The electronic devices 8202 and 8204 may be of a type that is the same as or different from the electronic device 8201. All or a part of operations executed in the electronic device 8201 may be executed in one or more electronic devices (8202, 8204, and 8208). For example, when the electronic device 8201 needs to perform a function or service, the electronic device 8201 may request one or more electronic devices to perform part of the whole of the function or service, instead of performing the function or service. The one or more electronic devices receiving the request may perform additional function or service related to the request, and transmit a result of the performance to the electronic device 8201. To this end, cloud computing, distributed computing, and/or client-server computing technology may be used.

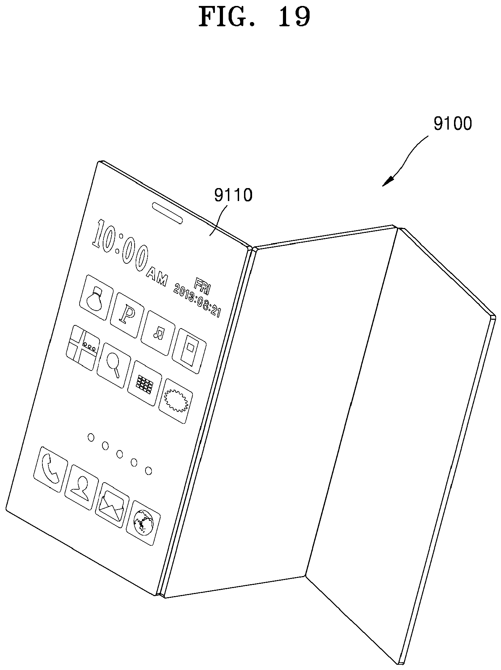

FIG. 19 shows an example in which an electronic device according to an embodiment is applied to a mobile device. A mobile device 9100 may include a display device 9110, and the display device 9110 may include the display devices according to embodiments. The display device 9110 may have a foldable structure, for example, a multi-foldable structure.

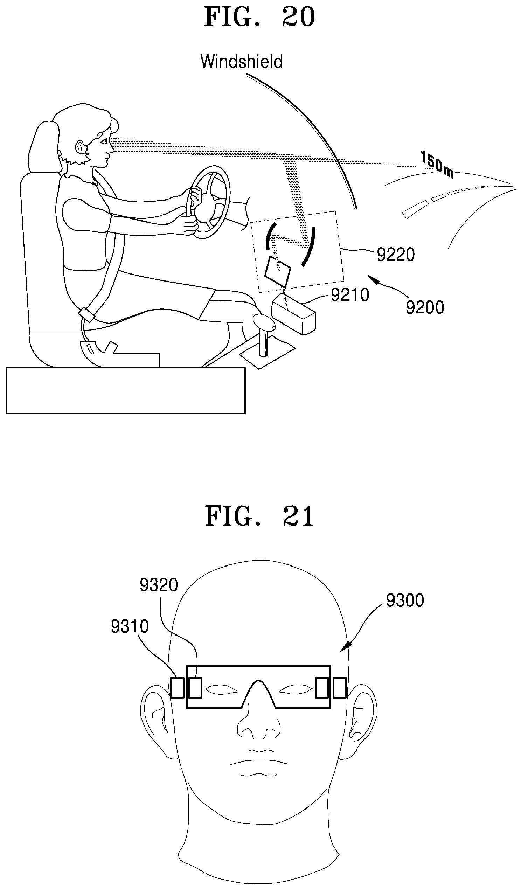

FIG. 20 shows an example in which a display device according to an embodiment is applied to a vehicle. The display device may be a head-up display device for vehicle 9200 and may include a display 9210 and an optical path change member 9220 configured to change an optical path so that a driver can see an image generated at the display 9210.

FIG. 21 shows an example in which a display device according to an embodiment is applied to augmented reality glasses or virtual reality glasses. The augmented reality glasses 9300 may include a projection system 9310 configured to form an image and an element configured to guide the image from the projection system 9310 to user's eyes. The projection system 9310 may include the display device according to an embodiment.

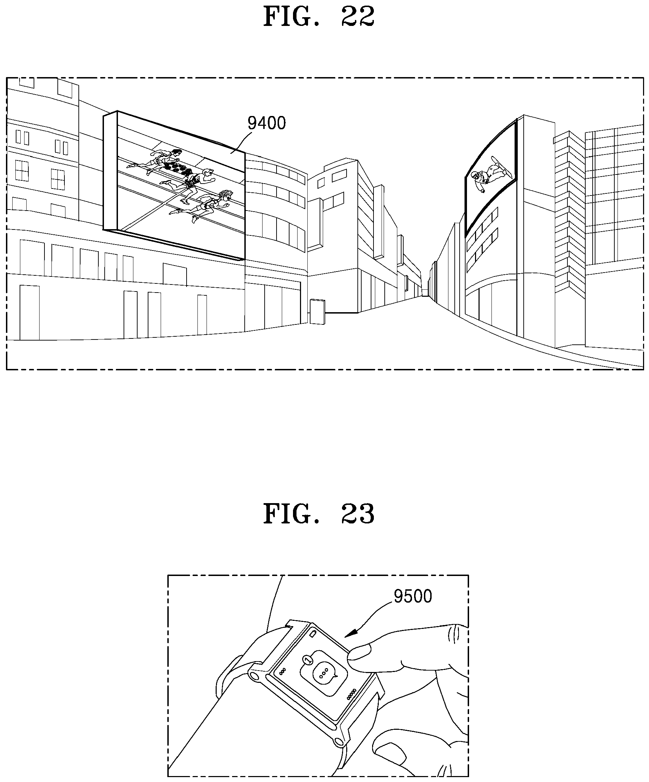

FIG. 22 is a diagram illustrating an example in which a display device according to an embodiment is applied to large signage. A signage 9400 may be used in outdoor advertising using a digital information display, and may control contents, etc. of an advertisement though a network. The signage 9400 may be implemented by, for example, the electronic device described with reference to FIG. 18.

FIG. 23 shows an example in which a display device according to an embodiment is applied to a wearable display. A wearable display 9500 may include the display device according to an embodiment, and may be implemented by the electronic device described with reference to FIG. 18.

The display device according to an embodiment may also be applied to various products such as rollable TV, stretchable display, etc.

The display device according to an embodiment may have a perpendicular electrode structure, and when the micro-semiconductor chip is omitted, the first pad structure may be provided such that the first pad for the first electrode is not in contact with the second electrode to prevent shorting.

The method of manufacturing a display device may provide a method of preventing occurrence of shorting when the micro-semiconductor chip is omitted.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display device comprising:
a display substrate including wiring therein;
a first pad provided on the display substrate and connected to the wiring;
a second pad provided on the display substrate, spaced apart from the first pad, and connected to the wiring; and
a micro-semiconductor chip including:
a first electrode,
a second electrode, and
a p-type semiconductor layer, an active layer, and an n-type semiconductor layer that are provided between the first electrode and the second electrode,
wherein the micro-semiconductor chip has a perpendicular electrode structure, in which the first electrode is connected to the first pad, and the second electrode is connected to the second pad, and
wherein the second electrode is not in contact with the first pad at a position where the micro-semiconductor chip is absent.

2. The display device of claim 1, wherein the first pad is arranged not to overlap the second electrode or has a shape not to overlap the second electrode.

3. The display device of claim 1 or 2, further comprising a dummy pad arranged between the first pad and the second pad on the display substrate and disconnected to the wiring.

4. The display device of claim 3, wherein the dummy pad is arranged between the first pad and the second pad and includes a same material as the first pad.

5. The display device of any preceding claim, wherein the first pad includes a contact portion in contact with the first electrode and a recess portion accommodating a portion of the second electrode such that the second electrode is not in contact with the first pad when the micro-semiconductor chip is absent.

6. The display device of any preceding claim, wherein the first pad has a circular shape with a rectangular-shaped recess, a rectangular shape with a rectangular-shaped recess, a C shape, or a semicircular shape.

7. The display device of any preceding claim, wherein the micro-semiconductor chip includes a first micro-semiconductor chip and a second micro-semiconductor chip, which are provided in one pixel constituting the display device, the first pad includes a pair of pads that are connected to the first micro-semiconductor chip and the second micro-semiconductor chip, respectively, and the second pad is connected to both of the first micro-semiconductor chip and the second micro-semiconductor chip.

8. The display device of claim 7, wherein the pair of pads of the first pad have symmetrical shapes and a symmetrical arrangement with respect to the second pad.

9. A method of manufacturing a display device by using a micro-semiconductor chip including a first electrode, an second electrode, and a p-type semiconductor layer, an active layer, and an n-type semiconductor layer that are provided between the first electrode and the second electrode, the method comprising:
forming a first pad for the first electrode and a second pad for the second electrode on a display substrate including wiring therein;
bonding the first electrode to the first pad by transferring the micro-semiconductor chip;
stacking an insulating layer on the micro-semiconductor chip;
exposing the n-type semiconductor layer of the micro-semiconductor chip and the second pad by patterning the insulating layer; and
forming the second electrode on the exposed n-type semiconductor layer and the second pad,
wherein the forming of the first pad includes forming the first pad in such a manner that the second electrode is not in contact with the first pad at a position where the micro-semiconductor chip is absent.

10. The method of claim 9, wherein the forming of the first pad includes arranging the first pad not to overlap the second electrode or forming the first pad to have a shape not to overlap the second electrode.

11. The method of claim 9 or 10, wherein a dummy pad which is disconnected from the wiring is further provided between the first pad and the second pad on the display substrate.

12. The method of claim 11, wherein the dummy pad is arranged between the first pad and the second pad and includes a same material as the first pad.

13. The method of any of claims 9 to 12, wherein the first pad includes a contact portion in contact with the first electrode and a recess portion accommodating a portion of the second electrode such that the second electrode is not in contact with the first pad when the micro-semiconductor chip is omitted.

14. The method of any of claims 9 to 13, wherein the first pad has a circular shape with a rectangular-shaped recess, a rectangular shape with a rectangular-shaped recess, a C shape, or a semicircular shape.

15. The method of any of claims 9 to 14, wherein the micro-semiconductor chip includes a first micro-semiconductor chip and a second micro-semiconductor chip, which are provided in one pixel constituting the display device, the first pad includes a pair of pads that are connected to the first micro-semiconductor chip and the second micro-semiconductor chip, respectively, and the second pad is connected to both of the first micro-semiconductor chip and the second micro-semiconductor chip, and optionally wherein the pair of pads of the first pad have symmetrical shapes and a symmetrical arrangement with respect to the second pad.
